# FASCICULE DE BREVET EUROPEEN

(11) **EP 2 197 029 B1**
(45) Date de publication et mention de la délivrance du brevet: **18.02.2015**
(21) Numéro de dépôt: 09178266.4
(22) Date de dépôt: 08.12.2009
(51) Int. Cl.: H01L 23/047, H01L 23/66

(54) **Circuit intégré hyperfréquence encapsulé dans un boîtier**
In ein Gehäuse eingekapselter integrierter Hyperfrequenz-Schaltkreis
Microwave frequency integrated circuit encapsulated in a housing

(30) Priorité: 10.12.2008 FR 0858421
(43) Date de publication de la demande: 16.06.2010
(73) Titulaire: Airbus Defence and Space SAS, 78130 Les Mureaux (FR)
(72) Inventeur: Farré, Robert, 31400 TOULOUSE (FR)
(74) Mandataire: Fourcade, Emmanuelle

(56) Documents cités:
- EP-A- 0 097 087
- EP-A- 1 341 228
- JP-A- 10 092 963
- JP-A- 2000 299 398
- US-A- 3 514 849
- US-A1- 2003 068 907

## Description

L'invention s'inscrit dans le domaine des circuits intégrés monolithiques hyperfréquence. Elle concerne plus particulièrement un tel circuit encapsulé dans un boîtier d'encapsulation, et un procédé d'encapsulation d'un tel circuit dans un tel boîtier.

Le traitement électronique des signaux à haute fréquence est mis en oeuvre par des composants et des circuits intégrés en matériaux semiconducteurs adaptés aux hyperfréquences (par exemple en arséniure de gallium AsGa et ses dérivés). Ces circuits intégrés sont appelés circuits intégrés monolithiques hyperfréquences, ou MMIC (pour l'anglais Microwave Monolithic Integrated Circuit). Leur domaine de fréquence est en général supérieur à 40 MHz pour des circuits de large bande, et dépasse fréquemment le GHz dans les technologies actuelles. Les circuits les plus courants travaillent dans des bandes de fréquences de 2 à 18 GHz, de 18 à 26 GHz, de 26 à 40 GHZ, de 40 à 50 GHz. On atteint actuellement des bandes de fréquence qui peuvent être centrées jusqu'à 89, 157 ou 183 GHz.

De tels circuits intégrés trouvent application dans tous les domaines, qu'il s'agisse du spatial, du militaire, ou du civil. On les utilise notamment pour la fabrication de radiomètres, altimètres, radars, etc., pour la fabrication d'amplificateurs, oscillateurs ou autres.

Un domaine d'application particulièrement préféré de l'invention, bien que non limitatif, est la fabrication d'amplificateurs hyperfréquence destinés au domaine spatial.

Les circuits intégrés hyperfréquence hybrides et leurs éléments associés sont protégés par encapsulation dans un boîtier d'encapsulation, ci-après désigné boîtier hybride, qui fait partie intégrante du circuit électrique. La présente invention s'intéresse plus particulièrement aux boîtiers hybrides métalliques, qui sont formés de façon classique d'une semelle métallique accordée en dilatation avec le substrat du circuit, et sur laquelle est fixée, notamment par brasure, une cloison périphérique métallique délimitant une zone de montage des composants du circuit. Les accès hyperfréquence sont réalisés par des contacts au travers d'inserts en céramique fixés à la cloison périphérique de manière à la traverser en assurant une isolation électrique. Une fermeture hermétique du boîtier est assurée, après montage du circuit, par un capot métallique qui est fixé sur un bord supérieur de la cloison périphérique.

A l'intérieur du boîtier, les composants nécessaires au traitement (amplification par exemple) des signaux hyperfréquence sont rassemblés sur un même substrat isolant, notamment en une céramique, déposé sur la semelle du boîtier. Ce substrat comporte des interconnexions entre les différents composants et avec les contacts traversants.

Lorsque le boîtier encapsulant le circuit est fermé, il forme, au-dessus du circuit, une cavité à l'intérieur de laquelle il peut se produire un phénomène de résonance électromagnétique compte-tenu des fréquences d'opération du circuit. Cette résonance peut s'avérer nuisible au bon fonctionnement des composants du circuit. Par exemple, elle peut donner lieu à un phénomène d'oscillation dans un circuit amplificateur. Il n'est pas toujours possible pour éviter ce phénomène de réduire la taille du boîtier, car d'une part celle-ci est contrainte par la taille des divers composants à enfermer, l'espacement nécessaire entre eux et les contraintes d'assemblage et de câblage, et d'autre part il est économiquement pénalisant de développer un nouveau boîtier spécifiquement adapté et de qualifier celui-ci pour les applications prévues.

Afin de réduire le phénomène de résonance lié aux modes de la cavité, il a par exemple été proposé dans l'art antérieur de placer un revêtement absorbant dans la gamme des hyperfréquences dans la cavité, sous le capot du boîtier.

Une solution alternative proposée par l'art antérieur est de diminuer la taille de la cavité au-dessus des composants du circuit électrique, afin de modifier ses modes de résonance et de la désaccoupler par rapport à la fréquence d'opération du circuit. Parmi cet art antérieur, on peut citer les documents japonais JP-A-1 0092963 ou JP-A-2000299398. Il est proposé dans ces documents d'introduire à l'intérieur du boîtier une cloche interne recouvrant le circuit intégré et créant au-dessus de lui une cavité de dimensions plus réduites que le volume interne du boîtier. Suivant les configurations proposées, cette cloche est collée à la semelle, ou maintenue contre cette dernière par le capot du boîtier en appui contre sa paroi supérieure. Une telle solution ne s'avère cependant pas entièrement satisfaisante, car elle n'est applicable qu'aux boîtiers de taille suffisamment importante pour permettre la mise en appui de la cloche sur la semelle, autour des composants du circuit.

L'invention vise à remédier aux inconvénients des boîtiers métalliques d'encapsulation des circuits intégrés hyperfréquence existant, notamment à ceux exposés ci-avant, en proposant un boîtier qui atténue efficacement la résonance liée aux modes de la cavité en son intérieur, tout en étant simple à fabriquer à partir de boîtiers existants, y compris ceux de taille réduite.

L'invention concerne un circuit selon la revendication 1. Par désaccouplées, on entend ici que les fréquences liées aux modes de la cavité, en particulier au mode fondamental de cavité, sont suffisamment éloignées de la bande de fréquence d'opération du circuit pour éviter l'apparition d'un phénomène de résonance à l'intérieur du boîtier. La couronne interne est entièrement appliquée, par son contour externe, sur toute sa périphérie, contre le contour interne de la cloison périphérique du boîtier, aux tolérances de fabrication près. Il en résulte avantageusement une continuité thermique et électrique entre la cloison périphérique du boîtier et la couronne interne.

La couronne interne permet avantageusement de réduire l'espace libre à l'intérieur du boîtier, en constituant un épaississement sur-mesure de la cloison périphérique permettant de modifier les modes de la cavité à l'intérieur de celui-ci. Il en résulte une augmentation de la performance du circuit intégré.

La forme et les dimensions de la couronne, notamment l'épaisseur de sa paroi périphérique, sont déterminées en fonction de la bande de fréquence d'opération des composants du circuit, par des calculs à la portée de l'homme du métier, pour former à l'intérieur du boîtier une cavité de fréquences désaccouplées par rapport à la fréquence d'opération des composants.

Le boîtier selon l'invention est avantageusement peu coûteux à fabriquer à partir des boîtiers existants. Il est obtenu en introduisant, à l'intérieur d'un boîtier existant, une couronne interne de dimensions et de forme adéquates pour obtenir l'effet souhaité.

L'invention s'applique avantageusement à partir de tout boîtier existant, quelle que soit sa taille. Il n'est pas nécessaire de disposer, à l'intérieur du boîtier, d'un espace spécifique pour la réception de la couronne sur la semelle autour des composants du circuit. Selon les configurations, cette dernière peut venir ou pas en contact avec le substrat ou la semelle du boîtier.

Un même boîtier peut être utilisé pour encapsuler un seul, ou une pluralité de circuits monolithiques intégrés, ainsi que leurs éléments associés.

Le boîtier est avantageusement fermé de manière hermétique.

Il n'existe aucun jeu à l'intérieur du boîtier entre la couronne et la cloison. Ceci s'avère particulièrement avantageux par exemple pour les applications dans lesquelles le boîtier est soumis au cours de son utilisation à des forces de vibration importantes, par exemple dans le domaine spatial. En plus d'une continuité thermique et électrique entre la couronne et la cloison périphérique du boîtier, on obtient ainsi avantageusement également une continuité mécanique.

Le collage est réalisé de manière classique en elle-même, notamment par application manuelle, par exemple à la seringue, d'une colle organique polymère chargée de particules métalliques.

En fonction des caractéristiques de fréquence des composants du circuit, la couronne peut comporter une paroi supérieure occupant toute la surface de la cavité formée par ladite couronne. Elle est configurée de manière à ce que cette paroi supérieure n'entre pas en contact avec le capot du boîtier, de manière à d'une part ne pas interdire la fermeture du capot, notamment par un procédé de fermeture à la molette, et d'autre part ne pas altérer le collage de la couronne effectué avant la fermeture. En particulier, lors d'un procédé de fermeture à la molette, on réalise de façon classique, au moyen de deux électrodes sous forme de roulettes, une soudure locale qui peut être rendue impossible si le capot est trop massif. Si la couronne est en contact avec le capot, par sa paroi supérieure ou même plus généralement par sa cloison périphérique, elle peut augmenter l'inertie thermique du capot, ce qui rend impossible l'échauffement à un niveau suffisant pour la réalisation des points de soudure nécessaires à la fermeture.

Selon une caractéristique avantageuse de l'invention, la couronne comporte sur une paroi périphérique des encoches pour son positionnement au-dessus d'inserts se disposant sur la semelle à la périphérie de la zone de montage. De tels inserts sont classiques en eux-mêmes. Ils supportent des contacts qui permettent de réaliser, entre autres, les accès hyperfréquence du boîtier, à travers la cloison périphérique de celui-ci.

Le capot du boîtier se présente de préférence sous forme d'une plaque.

Dans des modes de réalisation préférés de l'invention, la semelle, la cloison périphérique, le capot et la couronne sont réalisés dans le même matériau électriquement conducteur. Ce matériau est notamment un alliage à base de fer, nickel et cobalt, présentant un faible coefficient de dilatation thermique, c'est-à-dire un coefficient thermique proche de celui de l'alumine et de l'ordre de 6 ppm/°C.

Selon un procédé de modification des dimensions d'une cavité interne du boîtier selon l'invention, une épaisseur de paroi périphérique de la couronne interne est choisie en fonction de la bande de fréquence d'opération des composants du circuit, de manière à former une cavité dont la fréquence de résonance est désaccouplée par rapport à la bande de fréquence d'opération du circuit.

L'invention concerne également un procédé de fabrication selon la revendication 7 d'un circuit intégré monolithique hyperfréquence encapsulé dans un boîtier hybride selon l'invention, selon lequel on met en oeuvre les étapes suivantes. Les constituants du boîtier et la couronne se présentent initialement sous forme de d'éléments séparés. Pour les boîtiers standards utilisés de préférence dans le cadre de l'invention, la semelle et la cloison périphérique sont préalablement fixées l'une à l'autre. Le capot, sous forme d'une simple plaque, est un élément distinct, de même que la couronne.

Les composants du ou des circuits sont tout d'abord agencés de façon opérante sur le substrat déposé sur la semelle, dans la zone de montage délimitée par la cloison périphérique du boîtier. Les dimensions du boîtier sont choisies de manière à permettre un positionnement adéquat des composants et à pouvoir réaliser commodément les opérations d'assemblage.

La couronne interne, dont la forme et les dimensions, et notamment l'épaisseur de la paroi périphérique, sont déterminées en fonction de la ou des fréquences propres à donner à la cavité, de manière à former une cavité dont la fréquence de résonnance est désaccouplée par rapport à la bande de fréquence d'opération du circuit, est ensuite insérée dans le boîtier dans sa position opérante et collée contre la cloison périphérique.

Le boîtier est enfin fermé, de préférence de manière hermétique, par le capot déposé sur le bord supérieur de la cloison périphérique.

La fermeture peut être réalisée par tous moyens classiques en eux-mêmes. Le capot est notamment assemblé à la cloison périphérique par un procédé de fermeture à la molette. Tout autre procédé, tel que le collage ou la brasure par exemple, peut également être utilisé.

L'invention sera maintenant plus précisément décrite dans le cadre de modes de réalisation préférés, qui n'en sont nullement limitatifs, représentés sur les figures 1 à 3, dans lesquelles :
- la figure 1 représente en vue en perspective et en éclaté un boîtier selon l'invention, comprenant une couronne interne;
- la figure 2 montre en vue de dessus le boîtier de la figure 1 encapsulant un circuit intégré, avant fermeture ;
- et la figure 3 illustre en vue de dessus un boîtier selon l'invention, encapsulant un circuit intégré et ouvert, dans lequel la couronne comporte une paroi supérieure.

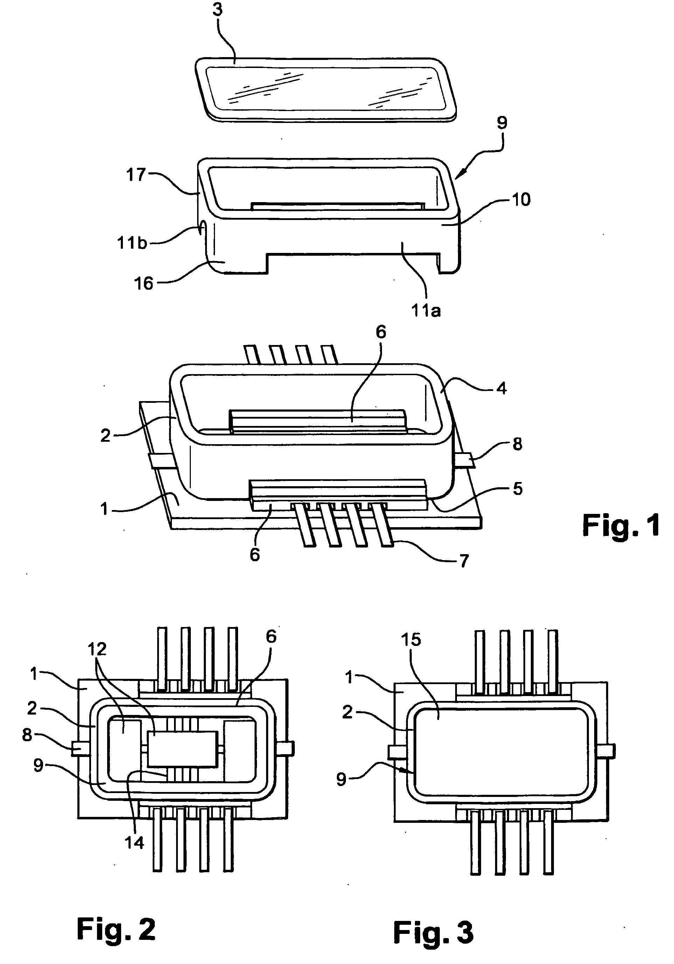

Un boîtier selon l'invention, pour l'encapsulation d'un, ou plusieurs, circuit intégré monolithique hyperfréquence hybride, ci-après désigné circuit, est représenté sur la figure 1.

Ce boîtier est constitué de manière à être électriquement conducteur. II est notamment formé en un matériau métallique ou métallisé. Dans des modes de réalisation préférés de l'invention, bien que non limitatifs, il est constitué en un alliage à base de fer, nickel et cobalt, à faible coefficient de dilatation thermique, accordé avec le coefficient de dilatation thermique du substrat du circuit, par exemple en alliage commercialisé sous la marque Kovar (marque déposée).

Le boîtier est classique en lui-même. Il comporte une semelle inférieure 1 sur laquelle est fixée, notamment par soudure, une cloison périphérique du boîtier 2. Cette cloison périphérique délimite à l'intérieur de son contour interne une zone de montage des composants du circuit. Un capot 3, sous la forme d'une plaque, se fixe par un bord supérieur 4 de la cloison, opposé à un bord inférieur 5 fixé sur la semelle, pour fermer le boîtier encapsulant le ou les circuits. Le boîtier présente une forme générale de section sensiblement rectangulaire. Il peut présenter toutes dimensions souhaitées. Selon l'invention, il peut s'agir avantageusement d'un boîtier normalisé, et qualifié pour un type d'application souhaitée, notamment dans le domaine spatial.

A l'intérieur de la zone de montage, un substrat, classique en lui-même, est déposé sur la semelle. Ce substrat est par exemple constitué en une céramique. Le ou les circuits intégrés sont formés sur ce substrat, et reliés entre eux et au substrat par des méthodes et des moyens classiques en eux-mêmes.

Deux inserts 6 classiques, formés en une matière isolante telle que par exemple une céramique, permettent de réaliser les raccordements électriques des circuits avec l'extérieur du boîtier. A cet effet, ils sont fixés à travers des parois longitudinales opposées de la cloison périphérique 2 de manière à relier les composants du circuit disposés à l'intérieur du boîtier et leur environnement extérieur, par l'intermédiaire d'éléments conducteurs externes 7 assurant l'alimentation, la transmission des signaux, etc.

Dans l'exemple de réalisation illustré d'un composant hyperfréquence, des pattes 8 traversant des parois latérales opposées de la cloison périphérique 2 assurent, de manière classique, la transmission des signaux radiofréquences entre l'extérieur et l'intérieur du boîtier.

Le boîtier comporte en outre une couronne interne 9 définie par une paroi périphérique 10 dont le contour externe coïncide sensiblement avec le contour interne de la cloison périphérique du boîtier 2. Par sensiblement, il faut comprendre dans le cas présent que les dimensions extérieures de la couronne sont aussi proches que possible des dimensions intérieures du boîtier sans gêner l'introduction et la fixation de la couronne. Lorsque la couronne 9 est introduite dans le boîtier, elle s'applique ainsi par son contour externe contre la cloison 2, assurant, une fois collée, une continuité thermique et électrique entre elle et la cloison. La continuité thermique est notamment particulièrement avantageuse en ce qu'elle favorise le refroidissement par rayonnement de l'intérieur du boîtier.

La couronne 9 présente ainsi une forme en section sensiblement rectangulaire, avec deux faces longitudinales et deux faces latérales.

La couronne 9 est réalisée de manière à être électriquement conductrice, notamment en matériau métallique. Dans des modes de réalisation préférés de l'invention, elle est formée dans le même matériau que le boîtier.

Sur des faces longitudinales, la couronne présente des encoches latérales 11a pour lui permettre de s'encastrer au-dessus des inserts 6 lorsqu'elle est placée à l'intérieur du boîtier. Afin d'éviter tout risque de courts-circuits avec les lignes électriques de ces inserts, la couronne 9 est avantageusement configurée de manière à ne pas entrer en contact avec eux.

De même, sur des faces latérales elle est pourvue d'encoches d'extrémité 11b pour le passage des pattes 8 du boîtier.

La couronne est placée dans le boîtier après que les composants du circuit aient été agencés et fixés sur le substrat.

Sur la figure 2, il est représenté un boîtier contenant trois circuits 13 distincts. Ces circuits sont reliés entre eux, et aux inserts 6, par des conducteurs 12. Ces circuits sont constitués de manière classique, notamment en arséniure de gallium.

La couronne 9 se dispose à l'intérieur du boîtier en appui contre la cloison latérale 2. Selon les configurations, elle peut ou non entrer en contact avec la semelle 1. Comme on peut le voir sur la figure, la couronne 9 se place au-dessus des éléments périphériques contenus dans le boîtier. Elle ne nécessite aucun espace spécifique sur la semelle 1 pour son appui et sa fixation. Elle s'adapte par conséquent à tous les boîtiers existants, même de petite taille. Elle ne nécessite aucune transformation particulière du boîtier.

Les dimensions et la forme de la couronne sont choisies en fonction des caractéristiques particulières du boîtier et des composants du ou des circuits qu'il enferme. Sa hauteur et son positionnement dans le boîtier sont toujours choisies de manière à assurer que la couronne n'entre pas en contact avec le capot, afin de ne pas interférer avec ledit capot 3 lorsque ce dernier est fixé sur le boîtier.

L'épaisseur de la couronne 9 est déterminée, par des calculs à la portée de l'homme du métier et le plus souvent vérifiés expérimentalement, de manière à assurer qu'elle détermine, à l'intérieur du boîtier, au-dessus des composants du circuit, une cavité dont les dimensions sont telles que ses fréquences propres sont désaccordées par rapport à la bande de fréquence d'opération des composants du circuit. Ces fréquences propres augmentent avec la diminution des dimensions de la cavité. Le phénomène de résonance lié aux modes de la cavité à l'intérieur du boîtier est par conséquent réduit à mesure que les fréquences de résonance s'éloignent des fréquences d'opération des circuits, et les performances des circuits hyperfréquence sont améliorées.

La couronne 9 est fixée à la cloison périphérique 2 du boîtier par collage, de préférence au niveau de ses quatre faces. Le collage est de préférence réalisé manuellement, en utilisant une seringue remplie de colle époxy chargée de particules métalliques.

Dans des modes de mise en oeuvre préférés de l'invention, la couronne est collée par sa partie inférieure 16 contre la cloison périphérique 2 du boîtier, de manière à améliorer la tenue à la vibration et la continuité électrique, puis par sa partie supérieure 17 contre cette même cloison, afin de combler le jeu entre la couronne 9 et la cloison.

La couronne 9 est ainsi rendue solidaire de la cloison périphérique 2. II ne peut y avoir aucun jeu entre ces éléments, et l'assemblage ainsi formé présente une bonne résistance mécanique, notamment aux vibrations.

Sur la figure 3 est représenté un boîtier comportant une couronne 9 répondant à un autre mode de réalisation préféré de l'invention. En plus de tout ce qui a été exposé précédemment, la couronne 9 comporte une paroi supérieure 15, qui recouvre entièrement sa surface, et qui permet de réduire encore les dimensions de la cavité dans le boîtier.

Lorsque la couronne a été installée à l'intérieur du boîtier, celui-ci est fermé, de manière hermétique, par le capot 3 déposé et fixé sur le bord supérieur 4 de la cloison périphérique. La fixation peut avantageusement s'effectuer par tout moyen classique, notamment par collage, brasure, ou fermeture à la molette. Afin de pouvoir être facilement soudé, il est tout à fait avantageux dans le cadre de l'invention que le capot présente une fine épaisseur.

Le circuit 13 se trouve alors encapsulé dans le boîtier, qui le protège.

La couronne interne 9 ne perturbe avantageusement pas les connexions électriques à l'intérieur du boîtier. Elle est parfaitement maintenue dans ce dernier. Elle ne nécessite aucun espace particulier sur la semelle pour sa fixation dans le boîtier.

L'invention s'applique à toutes les configurations de boîtiers, même les plus petits, et de circuits encapsulés. Le boîtier spécifique pour une application selon l'invention présente un faible coût de revient à partir d'un boîtier existant, et peu de contraintes de fabrication.

La description ci-avant illustre clairement que par ses différentes caractéristiques et leurs avantages, la présente invention atteint les objectifs qu'elle s'était fixés. En particulier, elle fournit un boîtier pour circuit intégré hyperfréquence qui permet à moindre coût, à partir d'un boîtier existant, de désaccoupler les fréquences de résonance de la cavité interne du boîtier par rapport à la bande de fréquence d'opération des composants du circuit.

## Revendications

1. Circuit intégré monolithique hyperfréquence (13) encapsulé dans un boîtier métallique comportant une semelle (1) sur laquelle est fixée par un bord inférieur (5) une cloison périphérique (2) délimitant à l'intérieur de son contour interne une zone de montage des composants du circuit, et un capot (3) fixé sur un bord supérieur opposé (4) de la cloison périphérique (2), le boîtier comportant une couronne interne électriquement conductrice (9) qui détermine un volume interne libre du boîtier formant une cavité dont la fréquence de résonance est désaccouplée par rapport à la bande de fréquence d'opération du circuit, dont le contour externe est appliqué contre le contour interne de la cloison périphérique (2) et de hauteur inférieure ou au plus égale à la hauteur de ladite cloison (2), **caractérisé en ce que** ladite couronne interne (9) est fixée par collage contre ladite cloison périphérique (2), de telle sorte qu'elle n'entre pas en contact avec ladite semelle (1).

2. Circuit encapsulé selon la revendication 1, **caractérisé en ce que** la couronne (9) comporte une paroi supérieure (15) occupant toute la surface de la cavité formée par ladite couronne.

3. Circuit encapsulé selon l'une quelconque des revendications 1 à 2, **caractérisé en ce que** la couronne (9) comporte sur une paroi périphérique des encoches (11a) pour son positionnement au-dessus d'inserts (6) se disposant sur ladite semelle (1) à la périphérie de ladite zone de montage.

4. Circuit encapsulé selon l'une quelconque des revendications 1 à 3, **caractérisé en ce que** le boîtier est fermé de manière hermétique.

5. Circuit encapsulé selon l'une quelconque des revendications 1 à 4, **caractérisé en ce que** la semelle (1), la cloison périphérique (2), le capot (3) et la couronne (9) sont réalisés dans le même matériau électriquement conducteur.

6. Circuit encapsulé selon la revendication 5, **caractérisé en ce que** la semelle (1), la cloison périphérique (2), le capot (3) et la couronne (9) sont réalisés en un alliage à base de fer, nickel et cobalt, à coefficient de dilatation thermique d'environ 6 ppm/°C.

7. Procédé de fabrication d'un circuit intégré monolithique hyperfréquence (13) encapsulé dans un boîtier selon l'une quelconque des revendications 1 à 6, **caractérisé en ce que** :
- les composants du circuit (13) sont agencés de façon opérante sur la semelle (1), dans la zone de montage délimitée par la cloison périphérique (2) du boîtier,
- la couronne interne (9) est insérée dans le boîtier et collée contre la cloison périphérique (2), de telle sorte qu'elle n'entre pas en contact avec ladite semelle,
- et le boîtier est fermé de manière hermétique par le capot (3) déposé sur le bord supérieur (4) de la cloison périphérique (2).

8. Procédé selon la revendication 7, **caractérisé en ce qu'**une épaisseur de la paroi périphérique de la couronne interne (9) est choisie en fonction de la bande de fréquence d'opération des composants du circuit (13), de manière à former une cavité interne dont la fréquence de résonance est désaccouplée par rapport à la bande de fréquence d'opération du circuit.

9. Procédé selon l'une des revendications 7 ou 8, **caractérisé en ce que** le capot (3) est assemblé à la cloison périphérique (2) par un procédé de fermeture à la molette.

## Patentansprüche

1. Monolithisch integrierte Mikrowellenschaltung (13), die in ein Metallgehäuse eingekapselt ist, das eine Sohle (1) umfasst, auf der eine umlaufende Wandung (2) über deren Unterkante (5) befestigt ist, die im Inneren ihrer internen Kontur eine Zone zur Montage der Bauteile der Schaltung eingrenzt, sowie eine Abdeckung (3), die an der gegenüber liegenden Oberkante (4) der umlaufenden Wandung (2) befestigt ist, wobei das Gehäuse einen elektrisch leitenden inneren Kranz (9) umfasst, der ein freies Innenvolumen des Gehäuses bestimmt und eine Vertiefung bildet, deren Resonanzfrequenz vom Betriebsfrequenzband der Schaltung abgekoppelt ist, deren externe Kontur an der internen Kontur der umlaufenden Wandung (2) anliegt, und niedriger oder zumindest gleich hoch ist, wie die besagte Wandung (2), **dadurch gekennzeichnet, dass** der besagte innere Kranz (9) durch Verkleben an der besagten Wandung (2) befestigt ist, sodass er die besagte Sohle (1) nicht berührt.

2. Eingekapselte Schaltung nach Anspruch 1, **dadurch gekennzeichnet, dass** der Kranz (9) eine obere Wandung (15) umfasst, die die gesamte Fläche der vom besagten Kranz gebildeten Vertiefung einnimmt.

3. Eingekapselte Schaltung nach irgendeinem der Ansprüche 1 bis 2, **dadurch gekennzeichnet, dass** der Kranz (9) an einer umlaufenden Wandung Einkerbungen (11a) zu seiner Positionierung oberhalb von Einsätzen (6) umfasst, die an der Peripherie der besagten Montagezone auf der besagten Sohle (1) angeordnet sind.

4. Eingekapselte Schaltung nach irgendeinem der Ansprüche 1 bis 3, **dadurch gekennzeichnet, dass** das Gehäuse hermetisch verschlossen ist.

5. Eingekapselte Schaltung nach irgendeinem der Ansprüche 1 bis 4, **dadurch gekennzeichnet, dass** die Sohle (1), die umlaufende Wandung (2), die Abdeckung (3) und der Kranz (9) aus demselben elektrisch leitenden Material gefertigt sind.

6. Eingekapselte Schaltung nach Anspruch 5, **dadurch gekennzeichnet, dass** die Sohle (1), die umlaufende Wandung (2), die Abdeckung (3) und der Kranz (9) aus einer Legierung basierend auf Eisen, Nickel und Kobalt mit einem Wärmeausdehnungskoeffizienten von etwa 6ppm/°C gefertigt sind.

7. Verfahren zur Herstellung einer monolithisch integrierten Mikrowellenschaltung (13), die in ein Gehäuse nach irgendeinem der Ansprüche 1 bis 6 eingekapselt ist, **dadurch gekennzeichnet, dass**:
- die Komponenten der Schaltung (13) in funktioneller Art und Weise in der Montagezone auf der Sohle (1) angeordnet sind, die von der umlaufenden Wandung (2) des Gehäuses eingegrenzt wird,
- der innere Kranz (9) in das Gehäuse eingesetzt, und an die umlaufende Wandung (2) geklebt wird, sodass er die besagte Sohle nicht berührt,
- und das Gehäuse von der Abdeckung (3) hermetisch verschlossen wird, die an der Oberkante (4) der umlaufenden Wandung (2) abgelegt wird.

8. Verfahren nach Anspruch 7, **dadurch gekennzeichnet, dass** eine Dicke der umlaufenden Wandung des inneren Kranzes (9) in Abhängigkeit vom Betriebsfrequenzband der Komponenten der Schaltung (13) ausgewählt wird, sodass eine innere Vertiefung gebildet wird, deren Resonanzfrequenz vom Betriebsfrequenzband der Schaltung abgekoppelt ist.

9. Verfahren nach einem der Ansprüche 7 oder 8, **dadurch gekennzeichnet, dass** die Abdeckung (3) durch einen Verschluss mittels Rändelrad auf der umlaufenden Wandung (2) montiert wird.

## Claims

1. A monolithic microwave frequency integrated circuit (13) encapsulated in a metal box, comprising a base (1) on which is fixed by a lower edge (5) a peripheral wall (2), bordering with the interior of its internal edge a circuit component assembly area, and a hood (3) fixed on an opposite upper edge (4) of the peripheral wall (2), the box comprising an electrically conductive internal crown (9), which determines a free internal volume of the box forming a cavity the resonance frequency of which is uncoupled with respect to the circuit operation frequency band, of which the external edge is applied against the internal edge of the peripheral wall (2), and having a height lower or at most equal to the height of said wall (2), **characterized in that** said internal crown (9) is fixed by bonding against said peripheral wall (2), in such a way that it does not come into contact with said base (1).

2. An encapsulated circuit according to claim 1, **characterized in that** the crown (9) comprises an upper wall (15), occupying the whole surface of the cavity formed by said crown.

3. An encapsulated circuit according to any one of claims 1 to 2, **characterized in that** the crown (9) comprises on a peripheral wall, notches (11a) for its positioning above inserts (6) being placed on said base (1) on the rim of said assembly area.

4. An encapsulated circuit according to any one of the claims 1 to 3, **characterized in that** the box is hermetically sealed.

5. An encapsulated circuit according to any one of the claims 1 to 4, **characterized in that** the base (1), the peripheral wall (2), the hood (3) and the crown (9) are made from the same electrically conductive material.

6. An encapsulated circuit according to claim 5, **characterized in that** the base (1), the peripheral wall (2), the hood (3) and the crown (9) are made from an alloy based on iron, nickel and cobalt, with a coefficient of thermal expansion of around 6ppm/°C.

7. A method of manufacturing a monolithic microwave frequency integrated circuit (13) encapsulated in a box according to any one of claims 1 to 6, **characterized in that**:
- the circuit (13) components are arranged in an operative way on the base (1), in the assembly area bordered by the peripheral wall (2) of the box,
- the internal crown (9) is inserted in the box and bonded against the peripheral wall (2), in such a way that it does not come into contact with said base,
- and the box is hermetically sealed by the hood (3), deposited on the upper edge (4) of the peripheral wall (2).

8. A method according to claim 7, **characterized in that** a thickness of the peripheral wall of the internal crown (9) is chosen in accordance with the operating frequency band of the circuit (13) components, so as to form an internal cavity the resonance frequency of which is uncoupled with respect to the circuit operation frequency band.

9. A method according to one of claims 7 or 8, **characterized in that** the hood (3) is assembled to the peripheral wall (2) by a thumbwheel closing method.
